(19) Europäisches Patentamt
European Patent Office
Office européen des brevets

(11) **EP 1 098 375 A1**

(12) **EUROPEAN PATENT APPLICATION**

(43) Date of publication:
**09.05.2001 Bulletin 2001/19**

(51) Int Cl.7: **H01L 33/00**, G02B 5/28

(21) Application number: **99870231.0**

(22) Date of filing: **05.11.1999**

(84) Designated Contracting States:
**AT BE CH CY DE DK ES FI FR GB GR IE IT LI LU MC NL PT SE**
Designated Extension States:
**AL LT LV MK RO SI**

(71) Applicants:
• **INTERUNIVERSITAIR MICRO-ELEKTRONICA CENTRUM VZW**
  **3001 Heverlee (BE)**
• **Universiteit Gent**
  **9000 Gent (BE)**

(72) Inventors:
• **Bienstman, Peter**
  **9090 Melle (BE)**
• **Baets, Roel**
  **9800 Deinze (BE)**

(74) Representative: **Van Malderen, Joelle et al**
  **Office Van Malderen,**
  **Place Reine Fabiola 6/1**
  **1083 Bruxelles (BE)**

(54) **Optical filter and Resonant Cavity LED comprising the said optical filter**

(57)     The invention relates to a system for guiding a beam of electromagnetic radiation, said system comprising at least a first stack of dielectric layers, said first stack comprising at least a first substack, a second substack and a third substack, separating said first and second substack, said first substack comprises at least one dielectric layer, said second substack comprises at least one dielectric layer, said third substack comprises at least one dielectric layer, dielectric layers of said first substack and said second substack having a same distance from said third substack, have the same refractive index and the sum of the thickness of dielectric layers of said first substack and said second substack having a same distance from said third substack is a multiple of half of the vacuum wavelength of said beam divided by the refractive index of said dielectric layers of said first substack and said second substack having a same distance from said third substack, said third substack thickness being substantially different from a quarter of the vacuum wavelength of said beam divided by the refractive index of said one dielectric layer of said third substack.

RCLED        RC²LED

FIG. 3

EP 1 098 375 A1

# Description

## Field of the invention

The present invention relates to a system for at least guiding or transferring a beam of electromagnetic radiation, said system comprising of planar media, more in particular a stack of dielectric media with a plurality of refractive indices and thicknesses. Said electromagnetic radiation can be light, in which case said system is denoted an optical system.

## Background of the invention

Recently, resonant cavity light emitting diodes have attracted considerable interest, mainly because of the possibility of increased extraction efficiency as compared to standard LEDs. Record efficiencies as high as 20 % have been reported e.g. in H. De Neve *et al., "Recycling of Guided Mode Light Emission in Planar Microcavity Light Emitting Diodes",* Appl. Phys. Lett., vol. 70, no. 7, pp. 799-801, 1997. However, these devices exhibit a wide radiation pattern, making them less suited to fiber applications.

In the past, efforts have been undertaken to design resonant cavity light emitting diodes with a narrower radiation pattern, as explained e.g. in R. Bockstaele *et al, "Resonant Cavity LED's Optimized for Coupling to Polymer Optical Fibers",* IEEE Phot. Techn. Lett., vol. 11, pp. 158-160, 1999. This approach involves growing an undertuned cavity, i.e. a cavity that is too short as compared to the resonance wavelength. This yields narrower radiation patterns, but unfortunately at the expense of lower extraction efficiencies, since the microcavity resonance only enhances a limited subset of the spectral and angular spectrum emitted by the active layer.

## Aim of the invention

It is an aim of the invention to provide a system showing such properties such that they can at least be exploited in the design of resonant cavities with narrow radiation patterns.

## Summary of the invention

The invented system guides a beam of electromagnetic radiation. Said system comprises a stack of dielectric layers with a plurality of refractive indices and thicknesses of said layers. In said system at least a first stack of dielectric layers with the following properties can be distinguished. Said first stack comprising at least a first substack, a second substack and a third substack, separating said first and second substack. Said first substack comprises of a plurality of dielectric layers or at least one, said second substack comprises of a plurality of dielectric layers or at least one. Dielectric layers of said first substack and said second substack having a same distance from said third substack are related to each other in the sense that at least they have the same refractive index. Moreover the sum of the thickness of dielectric layers of said first substack and said second substack having a same distance from said third substack is a multiple of half of the vacuum wavelength of said beam divided by the refractive index of said dielectric layers of said first substack and said second substrack having a same distance from said third substack.

In a first embodiment of the invention said third substack comprises at least a dielectric layer with a refractive index $n_c$ with a thickness being equal to a multiple of half of the vacuum wavelength of said beam divided by $n_c$.

In a second embodiment of the invention said system further comprises a second stack of dielectric layers. The number and thicknesses of the layers in said second stack are fully arbitrary.

According to a third embodiment of the invention, the parameters of said stack of said dielectric layers, both said first stack and said second stack, are chosen such that they cooperatively establish a high reflectance of said beam for off-axis incidence, a moderate reflectance of said beam for normal incidence and a negative equivalent penetration depth upon reflection of said beam.

According to a fourth embodiment of the invented system, said second stack of dielectric layers comprises of an alternating sequence of dielectric layers with refractive indices $n_1$ and $n_2$. The thickness of each of said dielectric layers are a quarter of the vacuum wavelength of said beam divided by the refractive index of the corresponding dielectric layer.

In a fifth embodiment of the invention, said second stack of dielectric layers, denoted stack A, is not present, leading to a structure, comprising said first stack, which is fully transparent for normal incidence of said beam, but exhibiting a high off-axis reflectance of said beam.

## Brief description of the drawings

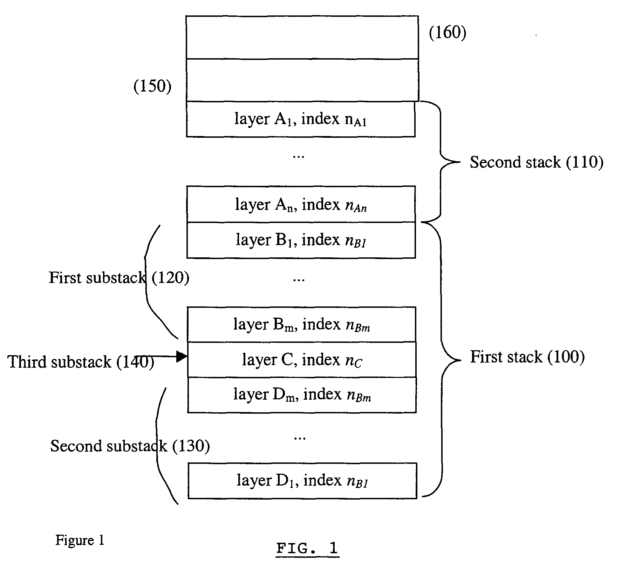

Figure 1 shows a first stack (100), comprising of a first substack (120), a second substack (130). Said first and second substacks are separated by a third substack (140). Said substacks comprise of dielectric layers. In an embodiment of the invention a second stack (110) of dielectric layers is present, said second stack being attached to said first stack. In a further embodiment of the invention a electromagnetic generating layer (150) is attached to said second stack. In yet another embodiment to said electromagnetic generating layer a third structure (160) is attached, said third structure can be but is not limited to be a metal reflector or a grating.

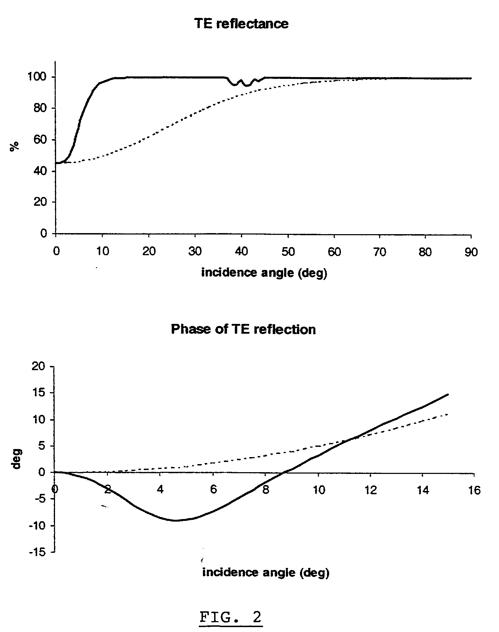

Figure 2 shows the TE reflectance, both amplitude (%) and phase (deg), of the system comprising said first stack and said second stack for normal incidence of said beam from the direction of said second stack. The full line shows the present invention, the dashed line shows the reflectance of a traditional DBR mirror. Here a vacuum wavelength of said beam is $\lambda_0 = 980$ nm, the refractive indices used in this embodiment are $n_1 = 1.55$, $n_2 = 3.5$. The negative equivalent penetration depth or negative phase is characteristic for the invention.

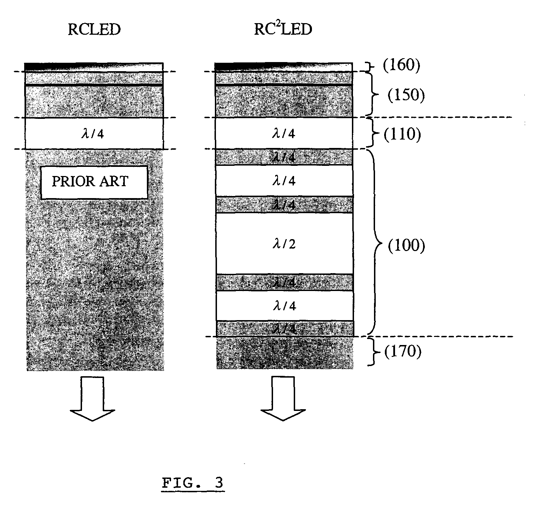

Figure 3 shows on the left prior art RCLED's and one the invented system, comprising a metal reflector, an electromagnetic radiation generating layer or cavity, a second stack, here comprising of one dielectric layer, a first stack comprising a first substack, a second substack and a third substack. Said first and second substacks comprising here of three dielectric layers, said third substack, comprising one dielectric layer. Said system is attached to a substrate (170).

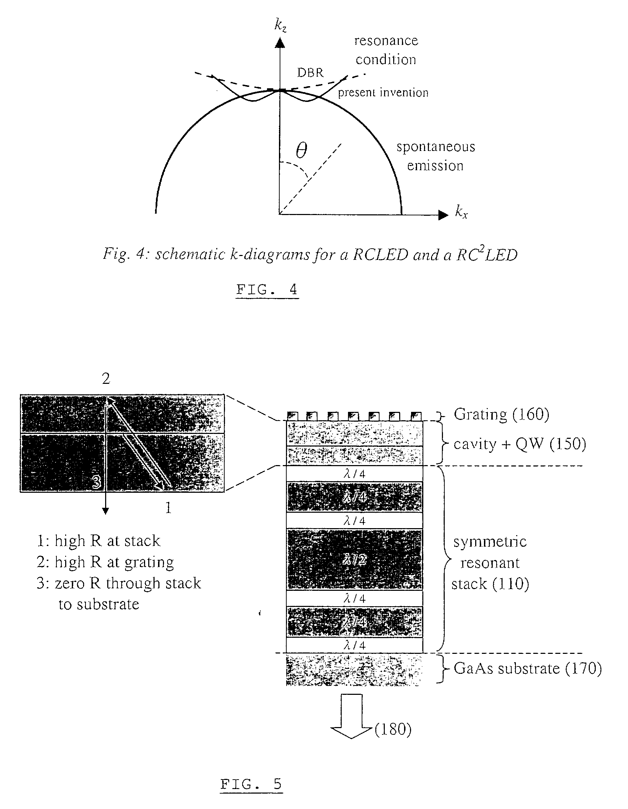

Figure 4 shows a schematic k-diagrams for a RCLED (prior art) (dotted line) and the invented system (full line). The negative equivalent penetration depth of the invented system results in at least more than one crossing of the circle representing spontaneous emission and the reflection characteristic of the system. Therefore at least more than one resonance condition is found.

Figure 5 shows an embodiment of the invention, exploiting a grating in order to enable resonance in a not normal direction. Said embodiment comprising of said first stack, an electromagnetic radiation generating layer and a grating. As said first stack is transparent for normal incidence and highly reflective for not normal incidence, such decoupling between resonance in one direction and transporting the resulting electromagnetic radiation outside the cavity (180) towards the substrate (170) is enabled.

**Detailed description**

Although detailed description and several embodiments of the invention are described below, the scope of the invention is determined only by the claims.

The invented system guides a beam of electromagnetic radiation. Said guiding of a beam can also be denoted transferring of a beam. Said system comprises planar media. Said system comprises a stack of dielectric layers with a plurality of refractive indices and thicknesses of said layers.

In said system at least a first stack of dielectric layers with the following properties can be distinguished. Said first stack comprising at least a first substack, a second substack and a third substack, separating said first and second substacks. Said first substack comprises of a plurality of dielectric layers, said second substack comprises of a plurality of dielectric layers. Dielectric layers of said first substack and said second substack having a same distance from said third substack are related to each other in the sense that at least they have the same refractive index. Moreover the sum of the thickness of dielectric layers of said first substack and said second substack having a same distance from said third substack is a multiple of half of the vacuum wavelength of said beam divided by the refractive index of said dielectric layers of said first substack and said second substrack having a same distance from said third substack. In Figure 1 said first substack layers are denoted B layers, said second substack layers are denoted D layers and said third substack layers are denoted C layers. In Figure 1 said third substack layer comprises of 1 layer but the invention is not limited thereto.

Said dielectric layers can be semiconducting material such as Al(x)Ga(1-x)As or InP but is not limited hereto. Dielectric layers with refractive indices in between 2.9 and 3.6 can be used but the invention is not limited hereto.

The thicknesses d of the layers in said first (B) and second substack (D) satisfy the following relationships with $n_x$ designates said refractive index of layer $x$, while $\lambda_0$ designates the vacuum wavelength of said beam.

$$d_{Bi} + d_{Di} = k_i \frac{\lambda_0}{2n_{Bi}}, \text{ with } i = 1..m \text{ and } k_i = 0,1,2,...$$

In a first embodiment of the invention the thickness d of said third substack C satisfies the relationship below. Said third substack comprises at least a dielectric layer with a refractive index $n_c$ with a thickness being equal to a multiple of half of the vacuum wavelength of said beam divided by $n_c$.

$$d_c = l \frac{\lambda_0}{2n_c}, \text{ with } l = 0,1,2,..$$

Under these conditions, the normal incidence transfermatrix for said first stack is always the unit matrix, meaning that for said normal incidence said first stack is fully transparent or opaque.

In a second embodiment of the invention said system further comprises a second stack of dielectric layers. The number and thicknesses of the layers in said second stack are fully arbitrary. Figure 1 shows that said second stack is placed on top of said first stack and thus attached to said first stack. However in the invention alternative placements of said first and second stack are possible, for instance the placement of said first stack and said second stack can be interchanged.

Moreover, said sequence of layers consisting of said first stack and second stack can be repeated an arbitrary number of times, if necessary with different material parameters in each repetition.

In an embodiment of said second embodiment said system comprises thus a periodic repetition of said first and said second stack.

In a further embodiment of said second embodiment in said system with periodic repetitions, the refractive index of said dielectric layers are different for at least two repetitions.

In another embodiment of said second embodiment said system comprises at least a periodic repetition of said first stack.

In a further embodiment of said second embodiment in said system with periodic repetition of said first stack, the refractive index of said dielectric layers are different for at least two repetitions.

According to a third embodiment of the invention, the parameters of said stack of said dielectric layers, both said first stack and said second stack, are chosen such that they cooperatively establish a high reflectance of said beam for off-axis incidence, a moderate reflectance of said beam for normal incidence and a negative equivalent penetration depth upon reflection of said beam.

It can be emphasized that said first stack is designed for establishing a high reflectance of said beam for off-axis incidence and realizing a negative equivalent penetration depth upon reflection of said beam, while said second stack is designed for moderate reflectance of said beam for normal incidence. As such said second stack of dielectric layers can be characterised as being substantially reflective for normal incidence radiation. Said first stack of dielectric layers can be characterised as being substantially transparent for normal incidence radiation and substantially reflective for off-axis incidence radiation. In the invention a spatial decoupling of the functionalities can thus be recognized. Moreover the exploitation of the phase characteristic of said reflectance of such systems is not known in the art.

According to a further embodiment of said third embodiment, said parameters of said first stack are chosen such that the reflectance of said beam is zero for normal incidence, while being very high for off-axis incidence.

According to a further embodiment of said third embodiment, said stack exhibiting said high off-axis incidence reflectance, said moderate normal incidence reflectance and said negative equivalent penetration depth replaces a traditional DBR reflector in a microcavity light emitting diode. Said high off-axis incidence reflectance provides for a narrow radiation pattern, while said negative equivalent penetration depth creates additional resonances in the extraction cone, thereby boosting the extraction efficiency. As compared to traditional DBR reflectors, said reflectance as a function of angle of said stack is such that the existence of leaky modes is greatly suppressed, thereby increasing the efficiency of the photon recycling mechanism. Such system can be characterised in that it comprises at least one electromagnetic generating layer. Further said electromagnetic generating layer is attached at one side to said second stack of dielectric layers. The system is thus being adapted for operating as an electromagnetic emitting device.

According to yet another embodiment of said third embodiment, said first stack exhibiting said zero normal incidence reflectance and said high off-axis incidence reflectance is used as a zero-loss outcoupling mirror in a surface emitting microcavity device. In this particular embodiment, another periodic structure couples one or more guided modes to modes propagating in a direction being substantially normal to the surface. Said off-axis propagating guided modes experience high reflectance upon incidence of said outcoupling mirror, thereby leading to high cavity Q-factors.

According to a fourth embodiment of the invented system, said second stack of dielectric layers comprises of an alternating sequence of dielectric layers with refractive indices $n_1$ and $n_2$. The thickness of each of said dielectric layers are a quarter of the vacuum wavelength of said beam divided by the refractive index of the corresponding dielectric layer. Said second stack of dielectric layers can be characterised as a traditional DBR stack of alternating layers with refractive indices $n_1$ and $n_2$, each having an optical thickness of a quarter wavelength.

According to a further embodiment of said fourth embodiment, said second stack of dielectric layers consists of a dielectric layer with refractive index $n_1$ and the thickness of said dielectric layer being a quarter of the vacuum wavelength of said beam divided by $n_1$.

According to a further embodiment of said fourth embodiment of the invented system, the first substack (B) of said first stack consists of a DBR with the same materials as said second substack, thus having said indices $n_1$ and $n_2$. Said first substack has an odd total number of layers $m$. Said third substack (C) has an optical thickness of half a wavelength, while said second substack (D) is then the mirror image of said first substack (B). Provided that said total number of layers $m$ is large enough, and/or that the refractive index contrast in said first substack is large enough, said reflectance of said beam will exhibit a negative equivalent penetration depth, i.e. a negative slope of the phase of said reflection coefficient of said beam as a function of incidence angle in the area around normal incidence under the assumption of a $exp(j\omega t)$ time convention. It is this negative equivalent penetration depth that one has to recognise for exploiting the invention in a microcavity LED.

In the special case said second stack consists of a single quarter-wavelength-layer (A) of material with said index $n_1$, and said first substack (B) consists of three quarter-wavelength-layers of alternating said indices $n_2$ -$n_1$ -$n_2$. Said third substack (C) is a half-wavelength-layer of material with said index $n_1$ while said second substack (D) has the same structure as said first substack (B). Figure 2 compares the reflection characteristics of said stack consisting of said sub-stacks A,B, C and D with those of a traditional DBR structure containing only said stack A and not said stacks B, C nor D. Both structures are embedded in a medium with said index $n_1$. Although for said characteristic said first stack and said second stack are not repeated, the invention is not limited thereto.

It is clear that the present invention yields much higher reflectivitities for off-axis incidence, while still maintaining the possibility of an arbitrary reflectance for normal incidence by choosing the number of layers in said second stack A. This contrasts to said traditional DBR mirrors, where increasing the number of layers leads to increase in reflectivity for both said normal and said off-axis incidence. Moreover, the slope of said reflection characteristic as a function of incidence angle of said beam is different for the present invention as compared to a said traditional DBR, leading to a negative equivalent penetration depth.

In a particularly promising further embodiment, said structure from said fourth embodiment replaces a traditional DBR mirror in a microcavity light emitting device. This device is henceforth referred to as a RC$^2$LED, while the known device with said DBR reflector is referred to as a RCLED. This device is henceforth referred to as a RC2LED, while the known device with said DBR reflector is referred to as a RCLED. Said name RC2LED stems from the presence of two resonant cavities (RC), one containing the electromagnetic generating region as in said RCLED, and one RC used in the reflector. The general properties of said two classes of devices are compared using the specific but not limiting examples of the devices outlined in Figure 3.

In a further particular but not limiting example, said devices are bottom emitting at 980 nm, have a top metal mirror *(n = 0.2 - 6.5 j)* doubling as a current contact, a 189 nm GaAs (*n* = 3.5) resonant cavity and a QW emitting at 980 nm placed at a field maximum. Said refractive indices in the bottom reflector are *$n_1$ = 1.55* and *$n_2$ = 3.5*. Since the transmission of said structure is only significant in a small cone around normal incidence, the radiation pattern of said RC$^2$LED will be much more narrow and directive as compared to said RCLED. Moreover, said negative equivalent penetration depth creates extra resonances in the extraction cone, leading to a higher extraction efficiency. The presence of extra resonances is further illustrated in fig. 4, comparing *k*-vector diagrams for said RCLED and said RC$^2$LED. Intersection points of the sphere representing spontaneous emission and of the surface representing the resonance condition correspond to resonantly enhanced emitted radiation. Both devices have a resonance for normal incidence ($\theta = 0$), but said RC$^2$LED exhibits a second resonance because of the negative equivalent penetration depth. The system can be characterised as a system being such that the equivalent penetration depth of said beam being negative.

The optical properties of said RCLED and said RC$^2$LED as outlined in said specific but not limiting example of fig. 3 were simulated assuming emitting dipoles oriented parallel to the interface in said stack, said dipoles having gaussian spontaneous emission spectrum with a FWHM of 45 nm centered at 980 nm, in the absence of a AR coating on the substrate and in the absence of the photon recycling effect. Both devices exhibit an extraction efficiency of about 18 %, but the radiation pattern of said RC$^2$LED is much narrower. For said RCLED, only 34 % of the light emitted into air falls within a NA of 0.5, whereas for said RC$^2$LED this figure is as high as 52 %. Furthermore, it is interesting to note that the phase of the reflection of said structure for normal incidence as a function of wavelength also exhibits a negative slope. This creates extra resonances in the wavelength domain, leading to an optical spectrum with multiple peaks. Moreover, in said RC$^2$LED, the presence of leaky modes is significantly suppressed as compared to said traditional RCLEDs, even when said RCLEDs use a larger number of pairs in said DBR. This increases the efficiency of the photon recycling effect. Note that the same degrees of freedom for device design such as changing the cavity length or changing the position of the active layer apply equally well to said RC$^2$LED as to said RCLED.

In a fifth embodiment of the invention, said second stack of dielectric layers, denoted stack A, is not present, leading to a structure, comprising said first stack, which is fully transparent for normal incidence of said beam, but exhibiting a high off-axis reflectance of said beam.

In a further embodiment the stack from the fifth embodiment is employed as a zero-loss outcoupling mirror in a surface emitting microcavity device. Said microcavity device furthermore contains a periodic structure coupling one or more guided modes to modes propagating in a direction being substantially normal to the surface. Said off-axis propagating guided modes experience high reflectance upon incidence of said outcoupling mirror, thereby leading to high cavity Q-factors, but at the same time providing for very low outcoupling loss.

The invented system can be described as a system for transferring a beam of electromagnetic radiation, said system comprising a stack of dielectric media with a plurality of refractive indices and thicknesses, said stack of said dielectric media containing one or more substacks exhibiting transparency upon normal incidence of said dielectric beam, the parameters of said system further being chosen such that they can cooperatively establish high reflectance upon off-axis incidence of said beam, arbitrary reflectance upon normal incidence of said beam and negative equivalent penetration depth of said beam. Said stack can be used as a mirror in a microcavity device. Said stack can also used as a mirror in a microcavity light emitting diode. Said mirror provides for a narrow radiation pattern and/ or a high extraction efficiency.

Alternatively said invented sytem can be described as a system for transferring a beam of electromagnetic radiation, said system comprising a stack of dielectric media with a plurality of refractive indices and thicknesses, the parameters of said system further being chosen such that said stack of said dielectric media is fully transparent for normal incidence of said dielectric beam and such that said stack of said dielectric media has high reflectance for off-axis incidence. Said stack can again be used as a mirror in a microcavity device or as an outcoupling mirror in a surface emitting microcavity device. When using said stack in said microcavity device, said device can further contain a periodic structure coupling one or more guided modes to modes propagating in a direction being substantially normal to the surface.

Said electromagnetic radiation in the invention can be in the range of microwave radiation. Said system can also be integrated in microwave antenna's.

## Claims

1. A system for guiding a beam of electromagnetic radiation, said system comprising at least a first stack of dielectric layers, said first stack comprising at least a first substack, a second substack and a third substack, separating said first and second substack, said first substack comprises at least one dielectric layer, said second substack comprises at least one dielectric layer, said third substack comprises at least one dielectric layer, dielectric layers of said first substack and said second substack having a same distance from said third substack, have the same refractive index and the sum of the thickness of dielectric layers of said first substack and said second substack having a same distance from said third substack is a multiple of half of the vacuum wavelength of said beam divided by the refractive index of said dielectric layers of said first substack and said second substack having a same distance from said third substack, said third substack thickness being substantially different from a quarter of the vacuum wavelength of said beam divided by the refractive index of said one dielectric layer of said third substack.

2. The system as recited in 1, wherein said third substack comprises at least a dielectric layer with a refractive index $n_c$ with a thickness being equal to a multiple of half of the vacuum wavelength of said beam divided by $n_c$.

3. The system as recited in 1, further comprising a second stack of dielectric layers.

4. The system as recited in 3, said second stack of dielectric being attached to said first stack of dielectric layers.

5. The system as recited in 4, comprising a periodic repetition of said first and said second stack.

6. The system as recited in 5, wherein the refractive index of said dielectric layers being different for at least two repetitions.

7. The system as recited in 1, comprising at least a periodic repetition of said first stack.

8. The system as recited in 7, wherein the refractive index of said dielectric layers being different for at least two repetitions.

9. The system as recited in 3, wherein said second stack of dielectric layers comprising an alternating sequence of dielectric layers with refractive indices $n_1$ and n2, the thickness of said dielectric layers being a quarter of the vacuum wavelength of said beam divided by the refractive index of said dielectric layer.

10. The system as recited in 3, wherein said second stack of dielectric layers consisting a dielectric layer with refractive index $n_1$ and the thickness of said dielectric layer being a quarter of the vacuum wavelength of said beam divided by $n_1$.

11. The system as recited in 1, wherein said first substack and said second substack each have an odd number of layers.

12. The system as recited in 11, wherein said first substack and said second substack comprising of dielectric layers with refractive indices $n_1$ and $n_2$.

13. The system as recited in 11, wherein said refractive indices being substantially different such that the equivalent penetration depth of said beam being negative.

14. The system as recited in 13, wherein said first substack comprises a first and second layer with refractive index $n_2$, a third layer with refractive index $n_1$, said first and said third layer being attached to each other, said second and said third layer being attached to each other, said first and said second layer not being attached to each other.

15. The system as recited in 13, wherein said first substack being a concatenation of a first layer with refractive index $n_2$, a second layer with refractive index $n_1$ and a third layer with refractive layer $n_2$.

16. The system as recited in 15, wherein said third substack being a dielectric layer with index $n_1$.

17. The system as recited in 3, further comprising at least one electromagnetic generating layer.

18. The system as recited in 17, said electromagnetic generating layer being attached at one side to said second stack of dielectric layers.

19. The system as recited in 17, wherein said electromagnetic generating layer being attached at its other side to a metal reflector.

20. The system as recited in 17, wherein said electromagnetic generating layer being attached at its other side to a grating.

21. The system as recited in 17, being adapted for operating as an electromagnetic emitting device.

22. The system as recited in 3, wherein said second stack of dielectric layers being substantially reflective for normal incidence radiation.

23. The system as recited in 22, wherein said reflectivity of said second stack being within the range of 40 to 70 %.

24. The system as recited in 23, wherein said reflectivity of said second stack being approximately 60%.

25. The system as recited in 1, wherein said first stack of dielectric layers being substantially transparant for normal incidence radiation and substantially reflective for off-axis incidence radiation.

26. The system as recited in 1, wherein said first stack of dielectric layers having a normal incidence matrix being substantially equal to the unit matrix.

27. The system as recited in 17, having a narrow radiation pattern.

28. A method for generating a first beam of electromagnetic radiation with a narrow radiation pattern, comprising the steps:
generating a second beam of electromagnetic radiation with a wide radiation pattern;
letting said second beam resonate in between a first and a second structure; wherein said first structure being substantially transparent for normal incidence of said second beam on said first structure and substantially reflective for off-axis incidence of said second beam and said second structure being adapted for partly reflecting said second beam in a off-axis direction; and said part of said second beam being transferred through said first structure being said first beam.

29. A method for generating a first beam of electromagnetic radiation with a narrow radiation pattern, comprising the steps:
generating a second beam of electromagnetic radiation with a wide radiation pattern;

letting said second beam resonate in between a first and a second structure; wherein said first structure being substantially transparent for normal incidence of said second beam on said first structure and said first structure being adapted for having a negative equivalent penetration depth; and
said part of said second beam being transferred through said first structure being said first beam.

30. A method for generating a first beam of electromagnetic radiation with a narrow radiation pattern, comprising the steps:
generating a second beam of electromagnetic radiation with a wide radiation pattern;
letting said second beam resonate in between a first and a second structure; wherein said first structure comprising a first substructure and a second substructure, said first substructure being substantially reflective for normal incidence for normal incidence of said second beam, said second substructure being substantially reflective for off-axis incidence of said second beam and substantially transparent for normal incidence of said second beam; and said part of said second beam being transferred through said first structure being said first beam.

Figure 1

FIG. 1

**TE reflectance**

**Phase of TE reflection**

FIG. 2

RCLED           RC²LED

FIG. 3

Fig. 4: schematic k-diagrams for a RCLED and a RC²LED

FIG. 4

1: high R at stack
2: high R at grating
3: zero R through stack
   to substrate

FIG. 5

## European Patent Office

## EUROPEAN SEARCH REPORT

Application Number

EP 99 87 0231

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 756 602 A (SOUTHWELL WILLIAM H ET AL) 12 July 1988 (1988-07-12)<br><br>* column 1, line 6 - column 2, line 27 * | 1-4,9, 11,12, 14-16 | H01L33/00<br>G02B5/28 |
| Y | * column 4, line 54 - column 5, line 27; figures 1,2 * | 17-21, 28,29 | |
| Y | EP 0 550 963 A (AMERICAN TELEPHONE & TELEGRAPH) 14 July 1993 (1993-07-14)<br>* page 4, line 6 - page 4, line 20 *<br>* page 8, line 26 - page 8, line 39; figure 7 * | 17-21, 28,29 | |
| X | EP 0 442 738 A (HEWLETT PACKARD CO) 21 August 1991 (1991-08-21)<br><br>* page 13, line 50 - page 14, line 12; figure 12A * | 1-4,9, 11,12, 14-16 | |
| A | HUNT N E J ET AL: "EXTREMELY NARROW SPECTRAL WIDTHS FROM RESONANT CAVITY LIGHT-EMITTING DIODES (RCLEDS) SUITABLE FOR WAVELENGTH-DIVISION MULTIPLEXING AT 1.3 MUM AND 1.55 MUM" INTERNATIONAL ELECTRON DEVICES MEETING (IEDM),US,NEW YORK, IEEE,1992, pages 651-654, XP000687513 ISBN: 0-7803-0818-2 * the whole document * | 17-21 | TECHNICAL FIELDS SEARCHED (Int.Cl.7)<br><br>H01L<br>G02B |
| D,A | BOCKSTAELE R ET AL: "RESONANT CAVITY LED'S OPTIMIZED FOR COUPLING TO POLYMER OPTICAL FIBERS" IEEE PHOTONICS TECHNOLOGY LETTERS,US,IEEE INC. NEW YORK, vol. 11, no. 2, February 1999 (1999-02), pages 158-160, XP000803414 ISSN: 1041-1135 * the whole document * | 17-21 | |

The present search report has been drawn up for all claims

| Place of search | Date of completion of the search | Examiner |
|---|---|---|
| MUNICH | 10 April 2000 | Lerbinger, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 99 87 0231

This annex lists the patent family members relating to the patent documents cited in the above-mentioned European search report.
The members are as contained in the European Patent Office EDP file on
The European Patent Office is in no way liable for these particulars which are merely given for the purpose of information.

10-04-2000

| Patent document cited in search report | | Publication date | Patent family member(s) | | Publication date |
|---|---|---|---|---|---|
| US 4756602 | A | 12-07-1988 | NONE | | |
| EP 0550963 | A | 14-07-1993 | US | 5226053 A | 06-07-1993 |
| | | | CA | 2083121 A,C | 28-06-1993 |
| | | | DE | 69214423 D | 14-11-1996 |
| | | | DE | 69214423 T | 20-02-1997 |
| | | | HK | 220496 A | 03-01-1997 |
| | | | JP | 5275739 A | 22-10-1993 |
| EP 0442738 | A | 21-08-1991 | US | 5144498 A | 01-09-1992 |
| | | | JP | 4213403 A | 04-08-1992 |

EPO FORM P0459

For more details about this annex : see Official Journal of the European Patent Office, No. 12/82